# EUROPEAN PATENT APPLICATION

(11) **EP 4 528 849 A1**
(43) Date of publication of application: **26.03.2025**
(21) Application number: 23877562.1
(22) Date of filing: 26.09.2023
(51) Int. Cl.: H01M 4/36, H01M 4/525, H01M 4/505, H01M 4/58, H01M 4/48, H01M 4/38, H01M 4/583, H01M 10/052, H01M 4/02

(54) **SECONDARY BATTERY**

(30) Priority: 14.10.2022 KR 20220132117; 25.09.2023 KR 20230127952
(71) Applicant: LG Energy Solution, Ltd., Seoul 07335 (KR)
(72) Inventor: KIM, Gwang Yeon, Daejeon 34122 (KR); OH, Sang Seung, Daejeon 34122 (KR); KIM, Seongsoo, Daejeon 34122 (KR); JEON, Jaebeom, Daejeon 34122 (KR); JO, Hanjoo, Daejeon 34122 (KR)
(74) Representative: Plasseraud IP
(86) International application number: PCT/KR2023/014828
(87) International publication number: WO 2024/080634

(57) **Abstract**

The present specification provides a secondary battery, which comprises a cathode, an anode, a separator, and an electrolyte, the anode containing a silicon-based active material and a carbon-based active material, the cathode containing: a lithium nickel-based active material in a single particle form; and at least one of LCO (LiCoO₂), LMO (LiMn2O4), and LFP (LiFePO4), in a secondary particle form, wherein the lithium nickel-based active material in a single particle form contains 55 mol% or more of nickel in 100 mol% of metals excluding lithium.

## Description

### [Technical Field]

This application claims priority to and the benefit of Korean Patent Application No. 10-2022-0132117 filed in the Korean Intellectual Property Office on October 14, 2022, and Korean Patent Application No. 10-2023-0127952 filed in the Korean Intellectual Property Office on September 25, 2023, the entire contents of which are incorporated herein by reference.

The present invention relates to a secondary battery.

### [Background Art]

Due to characteristics of being easily applicable to various products and electrical characteristics such as high energy density, a secondary battery is not only commonly applied to a portable device, but universally applied to an electric vehicle (EV) or a hybrid electric vehicle (HEV) that is driven by an electrical driving source.

The secondary battery is attracting attention as a new energy source to improve eco-friendliness and energy efficiency because of the primary advantage that the use of fossil fuels is dramatically reduced as well as the secondary advantage that no by-products are generated from the use of energy.

In general, a secondary battery includes a positive electrode, a negative electrode, a separator interposed between the positive electrode and the negative electrode, an electrolyte, and the like. In addition, the positive electrode and the negative electrode may be formed on current collectors with active material layers each including a positive electrode active material and a negative electrode active material. In general, for the positive electrode, a lithium-containing metal oxide such as LiCoO₂ and LiMn₂O₄ is used as the positive electrode active material, and for the negative electrode, a carbon-based compound, a silicon-based compound, a mixture thereof, or the like is used as the negative electrode active material.

Recently, in order to develop a battery allowing for rapid charging, a mixture of a carbon-based compound such as graphite and a silicon-based compound is used for a negative electrode. However, when the silicon-based compound is included, a resistance of the negative electrode increases rapidly at the end of discharge, resulting in an increase in difference between the resistance of the negative electrode and the resistance of the positive electrode, which shortens the life of the battery and deteriorates room temperature cycle characteristics. Therefore, there is a need to develop batteries to solve these problems.

### Citation List

### [Patent Document]

(Patent Literature 1) Korean Patent Application Publication No. 10-2012-0037409

### [Detailed Description of the Invention]

### [Technical Problem]

The present invention attempts to provide a secondary battery with improved life and room temperature cycle characteristics of the battery by reducing a difference between a resistance of a negative electrode and a resistance of a positive electrode at the end of discharge while including a silicon-based compound in a negative electrode active material layer.

However, the technical problem to be solved by the present invention is not limited to the above-described problem, and other problems not described will be apparently understood by one skilled in the art from the following description.

### [Technical Solution]

An exemplary embodiment of the present invention provides a secondary battery including a positive electrode, a negative electrode, a separator, and an electrolyte, wherein the negative electrode includes a silicon-based active material and a carbon-based active material, wherein the positive electrode includes a lithium nickel-based active material in the form of a single particle; and one or more of LCO (LiCoO₂), LMO (LiMn₂O₄) and LFP(LiFePO₄) in the form of secondary particles, and wherein the lithium nickel-based active material in the form of a single particle contains 55 mol% or more of nickel with respect to 100 mol% of metals excluding lithium.

### [Advantageous Effects]

The secondary battery of the present invention includes the lithium nickel-based active material in the form of a single particle and one or more of LCO (LiCoO₂), LMO (LiMn₂O₄) and LFP(LiFePO₄) in the form of secondary particles in the positive electrode active material layer, making it possible to reduce the rapid decrease in resistance of the positive electrode at the end of discharge. Accordingly, it is possible to obtain a secondary battery that allows for a reduction in the difference between the resistance of the negative electrode and the resistance of the positive electrode and has improved life and room temperature cycle characteristics.

Specifically, when a lithium nickel-based active material in the form of a single particle with a high nickel content is used for a positive electrode active material layer in order to increase the energy density of the battery and to reduce breakage of an active material and a silicon-based active material is included in a negative electrode active material layer in order to enable rapid charging, the resistance of the negative electrode rises rapidly at the end of discharge to result in a large difference between the resistance of the positive electrode and the resistance of the negative electrode, leading to an excessive increase in the use of the silicon-based active material included in the negative electrode active material layer (increase in depth of use) and a deterioration in the life performance of the battery. In order to improve the above problems, the lithium nickel-based active material in the form of a single particle; and one or more of LCO (LiCoO₂), LMO (LiMn₂O₄) and LFP (LiFePO₄) in the form of secondary particles are included in the positive electrode active material layer to enable rapid charging, to improve the resistance of the positive electrode, and to reduce a resistance difference between the positive electrode and the negative electrode and a depth of use of the silicon-based active material, resulting in a secondary battery with improved room temperature life.

### [Best Mode]

Hereinafter, the present invention will be described in detail. The following description is intended to aid understanding of the present invention, and does not determine or limit the scope of the invention.

In the present specification, when a part is referred to as "including" a certain component, it means that the part can further include another component, not excluding another component, unless explicitly described to the contrary.

Throughout the present specification, when a member is referred to as being "on" another member, the member can be in direct contact with another member or an intervening member may also be present.

It should be understood that the terms or words used throughout the specification should not be construed as being limited to their ordinary or dictionary meanings, but construed as having meanings and concepts consistent with the technical idea of the present invention, based on the principle that an inventor may properly define the concepts of the words or terms to best explain the invention.

As used herein, the singular forms "a", "an" and "the" are intended to include the plural forms as well, unless the context clearly indicates otherwise.

In the present specification, the crystallinity of the structure included in the positive electrode or negative electrode active material can be confirmed through X-ray diffraction analysis, and the X-ray diffraction analysis may be performed by using an X-ray diffraction (XRD) analyzer (product name: D4-endavor, manufacturer: Bruker), or by appropriately adopting devices that are used in the art, in addition to the above device.

In the present specification, the presence or absence of elements and the contents of elements in the positive electrode or negative electrode active material can be confirmed through ICP analysis, and the ICP analysis may be performed by using an inductively coupled plasma atomic emission spectrometer (ICPAES, Perkin-Elmer 7300).

In the present specification, the end of discharge refers to a region where the SOC (states of charge) of a full cell is 10% or less.

In the present specification, the "average particle diameter (D₅₀) may be defined as a particle diameter corresponding to 50% of the cumulative volume in the particle diameter distribution curve. The average particle diameter (D₅₀) may be measured using a laser diffraction method. For example, a method for measuring an average particle diameter (D₅₀) of the positive electrode active material may include dispersing particles of the positive electrode active material in a dispersion medium, introducing the dispersion into a commercially available laser diffraction particle size measuring device (e.g., HORIBA LA-960), irradiating the dispersion with ultrasonic waves of approximately 28 kHz with an output of 60 W, and then calculating an average particle diameter (D₅₀) corresponding to 50% of the cumulative volume in the measuring device.

In the present specification, the term "single particle" is a concept in contrast to the form of a secondary particle formed by agglomeration of tens to hundreds of primary particles, and means a particle composed of 10 or less primary particles. Specifically, in the present invention, the single particle may be a single particle composed of one primary particle, or may be a form of particle formed by agglomeration of several primary particles.

In the present specification, the term "primary particle" refers to the smallest unit of particle recognized when observing an active material through a scanning electron microscope, and "secondary particle" refers to a secondary structure formed by agglomeration of tens to hundreds of primary particles.
In the present specification, the expression "particle" refers to a granule with a size of micron, and when magnified and observed, the particle can be identified as 'grain' having a crystal form with a size of tens of nanometers. When the grain is further magnified and observed, it is possible to identify a separated region having a form in which atoms form a lattice structure in a predetermined direction, wherein the region is referred to as a 'crystallite'. A size of the particle observed by **X-**ray diffraction (XRD) is defined as a size of the crystallite. The size of the crystallite may be quantitatively determined from the Scherrer equation by using XRD data.

A secondary battery of the present invention includes a positive electrode, a negative electrode, a separator, and an electrolyte, wherein the negative electrode includes a silicon-based active material and a carbon-based active material, wherein the positive electrode includes a lithium nickel-based active material in the form of a single particle, and one or more of LCO (LiCoO₂), LMO (LiMn₂O₄) and LFP(LiFePO₄) in the form of secondary particles, and wherein the lithium nickel-based active material in the form of a single particle contains 55 mol% or more of nickel with respect to 100 mol% of metals excluding lithium.

In the present specification, when the negative electrode active material layer includes a silicon-based active material, the resistance of the negative electrode rapidly increases at the end of discharge, and the resistance of the positive electrode using a positive electrode material with low resistance characteristics decreases rapidly, so that a difference between the resistance of the negative electrode and the resistance of the positive electrode greatly increases. Accordingly, there is a problem that the deterioration of the negative electrode progresses rapidly, shortening the life of the battery and deteriorating room temperature cycle characteristics. In order to solve this problem, a lithium nickel-based active material in the form of a single particle is included in the positive electrode active material layer, along with one or more of LCO (LiCoO₂), LMO (LiMn₂O₄) and LFP (LiFePO₄) in the form of secondary particles, thereby reducing the rapid decrease in the resistance of the positive electrode, resulting in a battery with improved life and room temperature cycle characteristics.

### <Positive Electrode>

The positive electrode of the present invention includes a positive electrode active material layer, wherein the positive electrode active material layer includes a lithium nickel-based active material in the form of a single particle, and one or more of LCO (LiCoO₂), LMO (LiMn₂O₄) and LFP (LiFePO₄) in the form of secondary particles. In this case, the lithium nickel-based active material in the form of a single particle contains 55 mol% or more, and specifically, 55 mol% or more and less than 80 mol%, or 80 mol% or more of nickel with respect to 100 mol% of metals excluding lithium. The present invention includes one or more of LCO (LiCoO₂), LMO (LiMn₂O₄) and LFP (LiFePO₄) in the form of secondary particles and mixes the same with the lithium nickel-based active material to have the effect of reducing a voltage of the positive electrode at the end of discharge.

According to an exemplary embodiment of the present invention, the positive electrode includes a positive electrode active material layer, and the positive electrode active material layer includes a positive electrode active material including a lithium nickel-based active material in the form of a single particle; and one or more of LCO (LiCoO₂), LMO (LiMn₂O₄) and LFP (LiFePO₄) in the form of secondary particles.

According to an exemplary embodiment of the present invention, the positive electrode active material layer includes a lithium nickel-based active material in the form of a single particle and LCO (LiCoO₂) in the form of a secondary particle.

According to an exemplary embodiment of the present invention, the positive electrode active material layer includes a lithium nickel-based active material in the form of a single particle and LMO (LiMn₂O₄) in the form of a secondary particle.

According to an exemplary embodiment of the present invention, the positive electrode active material layer includes a lithium nickel-based active material in the form of a single particle and LFP (LiFePO₄) in the form of a secondary particle.

According to an exemplary embodiment of the present invention, the positive electrode active material layer includes a lithium nickel-based active material in the form of a single particle and one or more of LMO (LiMn₂O₄) and LFP (LiFePO₄) in the form of secondary particles.

In an exemplary embodiment of the present invention, one or more of LCO (LiCoO₂), LMO (LiMn₂O₄) and LFP (LiFePO₄) in the form of secondary particles is included in an amount of 0.1 to 10 parts by weight, and specifically 0.1 to 5 parts by weight, or 0.1 to 3 parts by weight with respect to 100 parts by weight of a total of the positive electrode active material of the positive electrode active material layer. In this case, the total of the positive electrode active material may refer to the lithium nickel-based active material in the form of a single particle or the lithium nickel-based active material in the form of a single particle and an additional active material. When the contents of one or more of LCO (LiCoO₂), LMO (LiMn₂O₄) and LFP (LiFePO₄) included in the positive electrode active material layer satisfy the range described above, an effect of suppressing deterioration in the negative electrode by suppressing an increase in potential of the negative electrode due to the decrease in the voltage of the positive electrode at the end of discharge is exhibited. In addition, since the charge/discharge capacity (mAh) per g of each of LCO (LiCoO₂), LMO (LiMn₂O₄) and LFP (LiFePO₄) is lower than the charge/discharge capacity (mAh) per g of the lithium nickel-based active material, if the contents of one or more of LCO (LiCoO₂), LMO (LiMn₂O₄) and LFP (LiFePO₄) exceed the range described above, the battery capacity may be reduced.

According to an exemplary embodiment of the present invention, an average particle diameter (D₅₀) of the lithium nickel-based active material in the form of a single particle is 3 µm to 10 µm.

The lithium nickel-based active material of the present invention may include a lithium composite metal oxide including nickel, lithium and one or more metals such as cobalt, manganese, or aluminum. More specifically, a lithium-nickel-manganese-cobalt-based oxide (e.g., Li(Ni_{g}Co_{q}Mnᵣ₁)O₂(here, 0<p<1, 0<q<1, 0<r1<1, p+g+r1=1) or Li(Niₚ₁Co_{q1}Mnᵣ₂)O₄ (here, 0<p1<2, 0<q1<2, 0<r2<2, p1+q1+r2=2), etc.), a lithium-nickel-cobalt-transition metal (M) oxide (e.g., Li(Ni)ₚ₂Co_{q2}Mnᵣ₃M_{S2})O₂ (here, M is selected from the group consisting of Al, Fe, V, Cr, Ti, Ta, Mg and Mo, and p2, q2, r3 and s2 are each independent atomic fraction of elements, 0<p2<1, 0 < q2 < 1, 0≤r3<1, 0<s2<1, p2+q2+r3+s2=1), etc.), and the like may be exemplified, and any one or two or more of these compounds may be included. However, the present invention is not limited thereto.

The positive electrode may further include a positive electrode current collector in addition to the positive electrode active material layer described above. In this case, the positive electrode active material layer is formed on at least one surface of the positive electrode current collector.

In the positive electrode, the positive electrode current collector is not particularly limited as long as it has conductivity without causing a chemical change in the battery. For example, stainless steel, aluminum, nickel, titanium, fired carbon, aluminum or stainless steel each surface-treated with carbon, nickel, titanium, silver, or the like, or the like may be used. In addition, the positive electrode current collector may typically have a thickness of 3 µm to 500 µm, and a surface of the current collector may be formed with microscopic irregularities to enhance adhesive force of the positive electrode active material. For example, the positive electrode current collector may be used in various forms such as a film, a sheet, a foil, a net, a porous body, a foamed body, and a non-woven fabric body.

The positive electrode active material layer may include a positive electrode conductive material and a positive electrode binder together with the positive electrode active material described above.

In this case, the positive electrode conductive material is used to impart conductivity to the electrode, and can be used without particular limitation as long as the positive electrode conductive material has electronic conductivity without causing a chemical change in a battery to be constituted. Specific examples may include graphite such as natural graphite and artificial graphite; a carbon-based material such as carbon black, acetylene black, Ketjen black, channel black, furnace black, lamp black, thermal black and carbon fiber; metal powders or metal fibers such as copper, nickel, aluminum and silver; a conductive whisker such as zinc oxide and potassium titanate; a conductive metal oxide such as titanium oxide; or a conductive polymer such as polyphenylene derivative, or the like, and any one thereof or a mixture of two or more thereof may be used.

In addition, the positive electrode binder serves to improve bonding between particles of the positive electrode active material and adhesion between the positive electrode active material and the positive electrode current collector. Specific examples may include polyvinylidene fluoride (PVDF), polyvinylidene fluoride-hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, polytetrafluoroethylene, polyethylene, polypropylene, ethylene-propylene-diene polymer (EPDM), sulfonated-EPDM, styrene butadiene rubber (SBR), fluoro rubber, or various copolymers thereof, and the like, and any one thereof or a mixture of two or more thereof may be used.

The positive electrode active material layer may be formed by applying a positive electrode slurry including a lithium nickel-based active material in the form of a single particle, one or more of LCO (LiCoO₂), LMO (LiMn₂O₄) and LFP (LiFePO₄) in the form of secondary particles, and a binder and/or a conductive material to at least one surface of the positive electrode current collector, and then drying and roll-pressing the slurry.

The positive electrode slurry according to an exemplary embodiment of the present invention may further include a solvent for positive electrode slurry formation. Specifically, the solvent for positive electrode slurry formation may include methylpyrrolidone (NMP) or the like in order to facilitate dispersion of components. In an exemplary embodiment of the present invention, a solid content of the positive electrode slurry may be 20 parts by weight to 85 parts by weight, and specifically 30 parts by weight to 80 parts by weight on the basis of 100 parts by weight of a total of the positive electrode slurry.

According to an exemplary embodiment of the present invention, a porosity of the positive electrode is 19% to 23%.

The porosity can be calculated as (1-(roll-pressing density/true density of electrode))*100(%).

The roll-pressing density can be calculated as follows.
roll-pressing density: electrode weight (g) excluding foil after roll-pressing electrode/electrode volume excluding foil (area of sample* thickness of electrode layer, cm³)

The electrode volume excluding the foil refers to a total volume including pores in the electrode, and is calculated as a product of a unit area of the sample and a thickness of an electrode layer after roll pressing.

The true density of an electrode is an inherent density of an electrode active material and refers to a density of only portions filled with a material excluding gaps between particles. The true density of an electrode is measured by applying Archimedes' principle in a manner of measuring a volume (solid + isolated pores) excluding open pores to calculate a density value, or by using a gas pycnometer.

### <Negative Electrode>

A negative electrode according to an exemplary embodiment of the present invention includes a negative electrode active material layer, and the negative electrode active material layer includes a silicon-based active material and a carbon-based active material.

According to an exemplary embodiment of the present invention, the negative electrode includes a negative electrode active material layer, and the negative electrode active material layer includes a silicon-based active material and a carbon-based active material.

The negative electrode may further include a negative electrode current collector in addition to the negative electrode active material layer described above. In this case, the negative electrode active material layer is formed on at least one surface of the negative electrode current collector. The negative electrode active material layer includes the silicon-based active material and the carbon-based active material. Furthermore, the negative electrode active material layer may further include a binder and/or a conductive material.

According to an exemplary embodiment of the present invention, the carbon-based active material can be used without particular limitation, and representative examples thereof may include crystalline carbon, amorphous carbon, or a combination thereof. Examples of the crystalline carbon may include graphite such as amorphous, plate-like, flake-like, spherical or fibrous natural graphite and artificial graphite, and examples of the amorphous carbon may include soft carbon (low-temperature fired carbon), hard carbon, mesophase pitch carbide, fired coke, and the like. The graphite may be natural graphite, artificial graphite, or a mixture thereof. The carbon-based active material may be included in an amount of 60 parts by weight or more and 99 parts by weight or less with respect to 100 parts by weight of a total of the negative electrode active material included in the negative electrode active material layer.

According to an exemplary embodiment, the negative electrode includes a silicon-based active material.

The active material including SiOx (0<x<2) as the silicon-based active material may be a silicon-based composite particle including SiOₓ (0<x<2) and a pore.

The SiOx (0<x<2) corresponds to a matrix in the silicon-based composite particle. The SiOₓ(0<x<2) may be a form of including Si and SiO₂, and the Si may form a phase. That is, x corresponds to a ratio of the number of O to Si included in the SiOₓ(0<x<2). When the silicon-based composite particle includes the SiOₓ (0<x<2), a discharge capacity of a secondary battery can be improved.

The silicon-based composite particle may further include at least one of an Mg compound and a Li compound. The Mg compound and the Li compound may correspond to a matrix in the silicon-based composite particle.

The Mg compound and/or the Li compound may be present in the SiOx (0<x<2) and/or on a surface of the SiOx (0<x<2). The initial efficiency of the battery can be improved by the Mg compound and/or the Li compound.

The Mg compound may include at least one selected from the group consisting of Mg silicate, Mg silicide, and Mg oxide. The Mg silicate may include at least one of Mg₂SiO₄ or MgSiO₃. The Mg silicide may include Mg₂Si. The Mg oxide may include MgO.

In an exemplary embodiment of the present specification, the Mg element may be included in an amount of 0.1 wt% to 20 wt% or 0.1 wt% to 10 wt% on the basis of 100 wt% of a total of the silicon-based active material. Specifically, the Mg element may be included in an amount of 0.5 wt% to 8 wt% or 0.8 wt% to 4 wt%. When the above range is satisfied, the Mg compound can be included in an appropriate content in the silicon-based active material, so the volume change of the silicon-based active material during charging and discharging of the battery can be easily suppressed, and the discharge capacity and initial efficiency of the battery can be improved.

The Li compound may include at least one selected from the group consisting of Li silicate, Li silicide, and Li oxide. The Li silicate may include at least one of Li₂SiO₃, Li₄SiO₄ and Li₂Si₂O₅. The Li silicide may include Li₇Si₂. The Li oxide may include Li₂O.

In an exemplary embodiment of the present invention, the Li compound may include a form of lithium silicate. The lithium silicate is represented by LiₐSi_{b}O_{c}(2≤a≤4, 0<b≤2, 2≤c≤5) and may be divided into crystalline lithium silicate and amorphous lithium silicate. The crystalline lithium silicate may be present in the silicon-based composite particle in a form of at least one lithium silicate selected from the group consisting of Li₂SiO₃, Li₄SiO₄ and Li₂Si₂O₅, and the amorphous lithium silicate may be a form of LiₐSi_{b}O_{c} (2≤a≤4, 0<b≤2, 2≤c≤5). However, the present invention is not limited thereto.

In an exemplary embodiment of the present specification, the Li element may be included in an amount of 0.1 wt% to 20 wt% or 0.1 wt% to 10 wt% on the basis of 100 wt% of a total of the silicon-based active material. Specifically, the Li element may be included in an amount of 0.5 wt% to 8 wt%, and more specifically, 0.5 wt% to 4 wt%. When the above range is satisfied, the Li compound can be included in an appropriate content in the silicon-based active material, so the volume change of the negative electrode active material during charging and discharging of the battery can be easily suppressed, and the discharge capacity and initial efficiency of the battery can be improved.

The content of the Mg element or Li element can be confirmed through ICP analysis. For the ICP analysis, a predetermined amount (about 0.01 g) of a negative electrode active material is precisely aliquoted, transferred to a platinum crucible, and completely decomposed on a hot plate by adding nitric acid, hydrofluoric acid and sulfuric acid thereto. Then, by using an inductively coupled plasma atomic emission spectrometer (ICP-AES, Perkin-Elmer 7300), a reference calibration curve is obtained by measuring the intensity of a standard liquid, which has been prepared using a standard solution (5 mg/kg), at an intrinsic wavelength of the Mg element or Li element. Subsequently, a pre-treated sample solution and a blank sample are introduced into the spectrometer, and by measuring the intensity of each component to calculate an actual intensity, calculating the concentration of each component based on the obtained calibration curve, and then performing a conversion such that the sum of the calculated concentrations of the components is equal to a theoretical value, the Mg element or Li element content in the prepared silicon-based active material can be analyzed.

In an exemplary embodiment of the present specification, a carbon layer may be provided on a surface of the silicon-based composite particle and/or inside the pore. Conductivity is imparted to the silicon-based composite particle by the carbon layer, so that the initial efficiency, life characteristics, and battery capacity characteristics of a secondary battery including the negative electrode active material including the silicon-based composite particle can be improved. A total amount of the carbon layer included may be 5 wt% to 40 wt% on the basis of 100 wt% of a total of the silicon-based composite particle.

In an exemplary embodiment of the present specification, the carbon layer may include at least one of amorphous carbon or crystalline carbon.

In an exemplary embodiment of the present invention, the silicon-based active material may be SiO_{β} (0<β<2) or a Si-C composite.

An average particle diameter (D₅₀) of the silicon-based active material may be 2 µm to 15 µm, specifically 3 µm to 12 µm, and more specifically 4 µm to 10 µm. When the above range is satisfied, a side reaction between the silicon-based composite particle and the electrolyte solution is controlled, and the discharge capacity and initial efficiency of the battery can be effectively implemented.

In the present specification, the average particle diameter (D₅₀) may be defined as a particle diameter corresponding to 50% of the cumulative volume in the particle diameter distribution curve of particles. The average particle diameter (D₅₀) may be measured using, for example, a laser diffraction method. In the laser diffraction method, in general, particle diameters ranging from a submicron range to several millimeters can be measured, and results with high reproducibility and high resolvability can be obtained.

In addition, in an exemplary embodiment of the present invention, the silicon-based active material is included in an amount of 1 part by weight to 15 parts by weight, preferably 1 part by weight to 10 parts by weight, and more preferably 5 parts by weight to 10 parts by weight with respect to 100 parts by weight of the total negative electrode active material. In this case, the total negative electrode active material may refer to the silicon-based active material and the carbon-based active material; or the silicon-based active material, the carbon-based active material, and an additional active material. When the content of the silicon-based active material satisfies the range described above, an improved effect in terms of energy density and cell resistance is obtained, and an excellent effect in terms of life is obtained because the volume expansion that occurs during charging/discharging is small.

According to an exemplary embodiment of the present specification, the negative electrode slurry may further include an additional negative electrode active material, in addition to the silicon-based active material described above.

As the additional negative electrode active material, a compound capable of reversible intercalation and deintercalation of lithium may be used. Specific examples may include a metallic compound capable of being alloyed with lithium, such as Si, Al, Sn, Pb, Zn, Bi, In, Mg, Ga, Cd, Si alloys, Sn alloys, or Al alloys; a metal oxide capable of doping and undoping lithium, such as SiO_{β}(0<β<2), SnO₂, vanadium oxide, lithium titanium oxide, and lithium vanadium oxide; a composite including the metallic compound and a carbonaceous material, such as a Si-C composite or a SnC composite; a carbon-based active material, and the like, and any one thereof or a mixture of two or more thereof may be used. In addition, a metal lithium thin film may be used as the negative electrode active material.

In an exemplary embodiment of the present invention, a weight ratio of the silicon-based active material and the additional negative electrode active material included in the negative electrode slurry may be 1:99 to 90:10, and specifically 1:99 to 50:50.

The negative electrode current collector is not particularly limited as long as it has conductivity without causing a chemical change in the battery. For example, for the current collector, copper, stainless steel, aluminum, nickel, titanium, fired carbon, aluminum or stainless steel each surface-treated with carbon, nickel, titanium, silver, or the like, or the like may be used. Specifically, transition metals that adsorb carbon well, such as copper and nickel, may be used for the current collector. A thickness of the current collector may be 6 µm to 20 µm. However, the thickness of the current collector is not limited thereto.

The binder may include at least one selected from the group consisting of polyvinylidenefluoride-hexafluoropropylene copolymer (PVDF-co-HFP), polyvinylidenefluoride, polyacrylonitrile, polymethylmethacrylate, polyvinyl alcohol, carboxymethylcellulose (CMC), starch, hydroxypropylcellulose, regenerated cellulose, polyvinylpyrrolidone, polytetrafluoroethylene, polyethylene, polypropylene, ethylene-propylene-diene monomer (EPDM), sulfonated EPDM, styrene butadiene rubber (SBR), fluoro rubber, poly acrylic acid, and the above-described materials in which a hydrogen is substituted with Li, Na, Ca, etc., and may also include various copolymers thereof.

The conductive material is not particularly limited as long as it has conductivity without causing a chemical change in the battery, and for example, graphite such as natural graphite or artificial graphite; carbon black such as acetylene black, Ketjen black, channel black, furnace black, lamp black, and thermal black; a conductive fiber such as a carbon fiber and a metal fiber; a conductive tube such as a carbon nanotube; fluorocarbon powder; metal powder such as aluminum and nickel powder; a conductive whisker such as zinc oxide and potassium titanate; a conductive metal oxide such as titanium oxide; a conductive material such as polyphenylene derivative, and the like may be used.

The negative electrode slurry may further include a thickener such as sodium carboxymethyl cellulose (Na-CMC), carboxymethyl cellulose lithium (Li-CMC), and cellulose nanofiber (CNF).

The negative electrode slurry according to an exemplary embodiment of the present invention may further include a solvent for negative electrode slurry formation. Specifically, the solvent for negative electrode slurry formation may include at least one selected from the group consisting of distilled water, ethanol, methanol, and isopropyl alcohol, and specifically, distilled water, in terms of facilitating dispersion of components.

In an exemplary embodiment of the present invention, a solid content of the negative electrode slurry may be 20 parts by weight to 75 parts by weight, and specifically 30 parts by weight to 70 parts by weight on the basis of 100 parts by weight of the total of the negative electrode slurry.

### <Secondary Battery>

A secondary battery according to an exemplary embodiment of the present invention may include a positive electrode, a negative electrode, a separator interposed between the positive electrode and the negative electrode, and an electrolyte. Since the positive electrode and the negative electrode have been described above, detailed descriptions are omitted.

The separator serves to separate the negative electrode and the positive electrode and to provide a migration path of lithium ions, in which any separator may be used as the separator without particular limitation as long as it is typically used in a secondary battery, and particularly, a separator having high moisture-retention ability for an electrolyte solution as well as a low resistance against migration of electrolyte ions may be preferably used. Specifically, a porous polymer film, for example, a porous polymer film manufactured from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. In addition, a usual porous non-woven fabric, for example, a non-woven fabric formed of high-melting point glass fibers, polyethylene terephthalate fibers, or the like may be used. Furthermore, a coated separator including a ceramic component or a polymer material may be used to secure heat resistance or mechanical strength, and the separator having a single layer or multilayer structure may be selectively used.

Examples of the electrolyte may include an organic liquid electrolyte, an inorganic liquid electrolyte, a solid polymer electrolyte, a gel-type polymer electrolyte, a solid inorganic electrolyte, or a molten-type inorganic electrolyte that may be used in the manufacturing of the lithium secondary battery, but are not limited thereto.

Specifically, the electrolyte may include a non-aqueous organic solvent and a metal salt.
As the non-aqueous organic solvent, for example, an aprotic organic solvent such as N-methyl-2-pyrrolidinone, propylene carbonate, ethylene carbonate, butylene carbonate, dimethyl carbonate, diethyl carbonate, gamma-butyrolactone, 1,2-dimetoxy ethane, tetrahydrofuran, 2-methyltetrahydrofuran, dimethyl sulfoxide, 1,3-dioxolane, formamide, dimethylformamide, dioxolane, acetonitrile, nitromethane, methyl formate, methyl acetate, phosphoric acid triester, trimethoxy methane, dioxolane derivative, sulfolane, methyl sulfolane, 1,3-dimethyl-2-imidazolidinone, propylene carbonate derivative, tetrahydrofuran derivative, ether, methyl propionate, or ethyl propionate may be used.

In particular, among the carbonate-based organic solvents, ethylene carbonate and propylene carbonate, which are cyclic carbonates, are high-viscosity organic solvents and can be preferably used because they have high permittivity to dissociate a lithium salt well. When the cyclic carbonate is mixed with a linear carbonate with low viscosity and low permittivity, such as dimethyl carbonate and diethyl carbonate, in a suitable ratio and used, an electrolyte having high electric conductivity may be prepared, and therefore, may be more preferably used.

A lithium salt may be used as the metal salt, and the lithium salt is a material that is readily soluble in the non-aqueous electrolyte solution, in which, for example, one or more selected from the group consisting of F⁻, Cl⁻, I⁻, NO₃⁻, N(CN)₂⁻, BF₄⁻, ClO₄⁻, PF₆⁻, (CF₃)₂PF₄⁻, (CF₃)₃PF₃⁻, (CF₃)₄PF₂⁻, (CF₃)₅PF⁻, (CF₃)₆P⁻, CF₃SO₃⁻, CF₃CF₂SO₃⁻, (CF₃SO₂)₂N⁻, (FSO₂)₂N⁻, CF₃CF₂(CF₃)₂CO⁻, (CF₃SO₂)₂CH⁻, (SF₅)₃C⁻, (CF₃SO₂)₃C⁻, CF₃(CF₂)₇SO₃⁻, CF₃CO₂⁻, CH₃CO₂⁻, SCN⁻ and (CF₃CF₂SO₂)₂N⁻ may be used as an anion of the lithium salt.

One or more additives, for example, a haloalkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte for the purpose of improving life characteristics of the battery, suppressing a decrease in capacity of a battery, improving a discharge capacity of a battery, and the like, in addition to the above-described electrolyte components.

Another exemplary embodiment of the present invention provides a battery module including the secondary battery as a unit cell, and a battery pack including the same. Since the battery module and the battery pack include the secondary battery having high capacity and high life and cycle characteristics, the battery module and the battery pack may be used as a power source of a medium to large sized device selected from the group consisting of an electric vehicle, a hybrid electric vehicle, a plug-in hybrid electric vehicle, and a power storage system.

### Mode for Invention

Hereinafter, preferred examples will be provided for better understanding of the present invention. It will be apparent to one skilled in the art that the examples are only provided to illustrate the present invention and various modifications and alterations are possible within the scope and technical spirit of the present invention. Such modifications and alterations naturally fall within the scope of claims included herein.

### <Example 1>

### <Preparation Example>

### <Preparation of Lithium Secondary Battery>

### Preparation of Positive Electrode

As a positive electrode active material, LiNi_{0.86}Co_{0.05}Mn_{0.08}Al_{0.01}O₂ (Ni: 86 mol% with respect to 100 mol% of metals excluding lithium, average particle diameter (D₅₀): 4 µm) in the form of a single particle and LFP (LiFePO₄) in the form of a secondary particle were used, and LFP (LiFePO₄) was included in an amount of 3 parts by weight with respect to 100 parts by weight of a total of the positive electrode active material of the positive electrode active material layer. A positive electrode slurry was prepared by adding the positive electrode active material, a binder, and a conductive material to N-methyl-2-pyrrolidone (NMP) as a solvent for formation of the positive electrode slurry at a weight ratio of 97:1.8:1.2.

The binder was polyvinylidene fluoride (PVDF), and the conductive material was carbon nanotubes (CNT).

The positive electrode slurry was coated on both surfaces of an aluminum current collector (thickness: 12 µm) serving as a positive electrode current collector with an electrode loading amount of 3.92 mAh/cm², roll-pressed and dried in a vacuum oven at 130°C for 10 hours to form a positive electrode active material layer, whereby a positive electrode was prepared.

### Preparation of Negative Electrode

A negative electrode slurry was prepared by adding artificial graphite, natural graphite (weight ratio of artificial graphite and natural graphite was 8:2, excluding SiO ratio) and SiO (included in an amount of 6 parts by weight with respect to 100 parts by weight of a negative electrode active material) as a negative electrode active material, a binder, carboxymethylcellulose (CMC), and a conductive material to distilled water as a solvent for formation of a negative electrode slurry at a weight ratio of 95.573:2.3:1.127:1.

The binder was styrene butadiene rubber (SBR), and the conductive material was carbon nanotubes (CNT).

The negative electrode slurry was coated on both surfaces of a copper current collector (thickness: 6 µm) serving as a negative electrode current collector with an electrode loading amount of 4.10 mAh/cm², roll-pressed and dried in a vacuum oven at 130°C for 10 hours to form a negative electrode active material layer.

### Preparation of Lithium Secondary Battery

A lithium secondary battery was prepared by using the positive electrode and negative electrode described above, using, as a separator, a multilayered polyethylene/polypropylene/polyethylene separator (thickness: 14 µm) and injecting a non-aqueous organic solvent including lithium salt as an electrolyte (N/P ratio: 104.7%, weight of finished cell: 502.0 g, thickness of finished cell: 8.24 mm).

### <Examples 1 to 6 and Comparative Examples 1 to 5>

A Lithium secondary battery was prepared in the same manner as in Example 1, except that, only types and compositions of the positive electrode active material or the added compound were different from Example 1, as shown in Table 1 below.

**[Table 1]**

| | Type of lithium nickel-based active material | Type of additive | Parts by weight of additive (with respect to 100 parts by weight of positive electrode active material) |
|---|---|---|---|
| Example 2 | LiNi_{0.86}Co_{0.05}Mn_{0.0 8}Al_{0.01}O₂ (Ni: 86 mol%) in the form of single particle | LCO (LiCoO₂) in the form of secondary particle | 3 parts by weight |
| Example 3 | LiNi_{0.86}Co_{0.05}Mn_{0.0 8}Al_{0.01}O₂ (Ni: 86 mol%) in the form of single particle | LMO (LiMn₂O₄) in the form of secondary particle | 3 parts by weight |
| Example 4 | LiNi_{0.86}Co_{0.05}Mn_{0.0 8}Al_{0.01}O₂ (Ni: 86 mol%) in the form of single particle | LFP (LiFePO₄) in the form of secondary particle | 1 part by weight |
| Example 5 | LiNi_{0.6}Co_{0.1}Mn_{0.3}O₂ (Ni:60 mol%) in the form of single particle | LFP (LiFePO₄) in the form of secondary particle | 3 parts by weight |
| Example 6 | LiNi_{0.86}Co_{0.05}Mn_{0.0 8}Al_{0.01}O₂ (Ni: 86 mol%) in the form of single particle | LFP (LiFePO₄) in the form of secondary particle | 5 parts by weight |
| Comparative Example 1 | LiNi_{0.86}Co_{0.05}Mn_{0.0 8}Al_{0.01}O₂ (Ni: 86 mol%) in the form of single particle | - | - |
| Comparative Example 2 | LiNi_{0.86}Co_{0.05}Mn_{0.0 8}Al_{0.01}O₂ (Ni: 86 mol%) in the form of single particle | LFP (LiFePO₄) in the form of secondary particle | 15 parts by weight |
| Comparative Example 3 | LiNi_{0.86}CO_{0.05}Mn_{0.0 8}Al_{8.01}O₂ (Ni: 86 mol%) in the form of single particle | in the form of secondary particle | 20 parts by weight |
| Comparative Example 4 | LiNi_{0.86}Co_{0.05}Mn_{0.0 8}Al_{0.01}O₂ (Ni: 86 mol%) in the form of secondary particle | LFP (LiFePO₄) in the form of secondary particle | 3 parts by weight |
| Comparative Example 5 | lithium nickel-based active material including 30 mol% of Ni in the form of single particle | LFP (LiFePO₄) in the form of secondary particle | 3 parts by weight |

The capacity retention rate and resistance increase rate of the battery were measured as a result of 100 cycles of room temperature life in-situ using the different positive electrode active materials according to Examples 1 to 6 and Comparative Examples 1 to 5, and the results are shown in Table 2 below.

**[Table 2]**

| | V cutoff (V) | Cycle | Capacity (Ah) (25C/0.33C 0.5C/SOC0-100) | Capacity retention (%) (25C/0.33C 0.5C/SOC0-100) | R increase (%) |
|---|---|---|---|---|---|
| Example 1 | 2.5 | 100 | 40.3 | 96.1 | 15.3 |
| Example 2 | | | 40.5 | 93.7 | 17.3 |
| Example 3 | | | 39.5 | 94.7 | 16.9 |
| Example 4 | | | 40.8 | 94.2 | 16.3 |
| Example 5 | | | 39.1 | 97.1 | 14.5 |
| Example 6 | | | 40.1 | 95.7 | 16.1 |
| Comparative Example 1 | | | 41.0 | 85.8 | 40.9 |
| Comparative Example 2 | | | 37.9 | 91.2 | 23.5 |
| Comparative Example 3 | | | 36.9 | 89.3 | 29.4 |
| Comparative Example 4 | | | 40.2 | 90.3 | 21.3 |
| Comparative Example 5 | | | 31.5 | 94.5 | 18.5 |

As can be seen from the results of Examples 1 to 6 in Table 1, it could be confirmed that, when one or more of LCO (LiCoO₂), LMO (LiMn₂O₄) and LFP (LiFePO₄) in the form of secondary particles were added to the lithium nickel-based active material including 55 mol% or more of nickel with respect to 100 mol% of metals excluding lithium, the potential of the positive electrode at the end of discharge was rapidly dropped to suppress the increase in the potential of the negative electrode, resulting in a reduction in the resistance increase rate of the negative electrode and an excellent capacity retention rate. As can be seen in Table 1 above, Comparative Example 1 corresponds to the positive electrode including, as the positive electrode active material, only LiNi_{0.86}Co_{0.05}Mn_{0.08}Al_{0.01}O₂ (Ni: 86 mol% with respect to 100 mol% of metals excluding lithium, average particle diameter (D₅₀): 4 µm). In this case, the resistance increase rate of the negative electrode increased by about 25%, as compared with the positive electrode in which LFP (LiFePO₄) in the form of secondary particle was added, the depth of use of the negative electrode increased, and it could be confirmed through the capacity retention rate evaluation that the capacity retention rate was dropped by about 10% after 100 cycles.

Comparative Examples 2 and 3 correspond to cases where the positive electrode active material included LFP (LiFePO₄) in the form of secondary particles, but the weight ratio exceeded 10 parts by weight with respect to 100 parts by weight of the positive electrode active material. In this case, it can be confirmed that the resistance increase rate and the capacity retention rate were inferior to Examples 1 to 6, and the battery capacity was inferior to the batteries including less than 10 parts by weight of the positive electrode active material.

Comparative Example 4 corresponds to a case where the lithium nickel-based active material was changed to the form of a secondary particle. In this case, it can be confirmed that the result is similar to Examples 1 to 6 in terms of capacity, but the resistance increase rate is about 5% greater than those of Examples 1 to 6, so the effect is inferior in terms of capacity retention rate.

Comparative Example 5 corresponds to a case of using a compound in which the parts by weight of nickel in the lithium nickel-based active material was less than 55 mol%. In this case, it can be confirmed that the results are similar to Examples 1 to 6 in terms of resistance increase rate and capacity retention rate, but the capacity is clearly low.

## Claims

1. A secondary battery comprising:
a positive electrode;
a negative electrode;
a separator; and
an electrolyte,
wherein the negative electrode comprises a silicon-based active material and a carbon-based active material,
wherein the positive electrode comprises a lithium nickel-based active material in the form of a single particle, and one or more of LCO (LiCoO₂), LMO (LiMn₂O₄) and LFP (LiFePO₄) in the form of secondary particles, and
wherein the lithium nickel-based active material in the form of a single particle contains 55 mol% or more of nickel with respect to 100 mol% of metals excluding lithium.

2. The secondary battery of claim 1, wherein one or more of LCO (LiCoO₂), LMO (LiMn₂O₄), and LFP (LiFePO₄) in the form of secondary particles is comprised in an amount of 0.1 to 10 parts by weight with respect to 100 parts by weight of a positive electrode active material.

3. The secondary battery of claim 1, wherein the positive electrode has a porosity of 19% to 23%.

4. The secondary battery of claim 1, wherein the silicon-based active material is comprised in an amount of 1 to 15 parts by weight with respect to 100 parts by weight of a negative electrode active material.

5. The secondary battery of claim 1, wherein an average particle diameter (D₅₀) of the lithium nickel-based active material in the form of a single particle is 3 µm to 10 µm.

6. The secondary battery of claim 1, wherein the positive electrode comprises a lithium nickel-based active material in the form of a single particle, and one or more of LMO (LiMn₂O₄) and LFP (LiFePO₄) in the form of secondary particles.

7. The secondary battery of claim 1, wherein the positive electrode comprises one or more of LCO (LiCoO₂), LMO (LiMn₂O₄) and LFP (LiFePO₄) in the form of secondary particles in an amount of 0.1 to 3 parts by weight with respect to 100 parts by weight of a positive electrode active material.

8. The secondary battery of claim 1, wherein the lithium nickel-based active material in the form of a single particle contains 55 mol% or more and less than 80 mol% of nickel with respect to 100 mol% of metals excluding lithium.

9. The secondary battery of claim 1, wherein the lithium nickel-based active material in the form of a single particle contains 80 mol% or more of nickel with respect to 100 mol% of metals excluding lithium.
